# EUROPEAN PATENT APPLICATION

(11) **EP 4 723 484 A1**
(43) Date of publication of application: **08.04.2026**
(21) Application number: 25205934.0
(22) Date of filing: 01.10.2025
(51) Int. Cl.: H03M 1/10, H03M 1/18

(54) **ANALOG-TO-DIGITAL CONVERTER WITH DYNAMIC FULL-SCALE RANGE**

(30) Priority: 07.10.2024 US 202418908564
(71) Applicant: Avago Technologies International Sales Pte. Limited, Singapore 768923 (SG)
(72) Inventor: Conta, Matteo, Irvine, CA, 92603 (US); Cao, Zhiheng, Irvine, CA, 92603 (US); Kamath, Abhishek Prasad, San Jose, CA, 95132 (US)
(74) Representative: Grünecker Patent- und Rechtsanwälte PartG mbB

(57) **Abstract**

An example receiver includes a comparator configured to compare an analog signal and a reference signal; an analog-to-digital converter (ADC) having an input configured to receive the analog signal and an output configured to supply a digital signal; a first circuit configured to supply the analog signal to the input of the ADC, the first circuit configured to apply, under control by output of the comparator, a first operation to the analog signal; and a second circuit configured to receive the digital signal from the output of the ADC, the second circuit configured to apply, under control of the output of the comparator, a second operation to the digital signal. In some examples, the analog signal can be an orthogonal frequency division multiplexing (OFDM) signal.

## Description

### BACKGROUND

An analog-to-digital converter (ADC) may be a circuit that converts an analog signal into a digital signal. An analog signal may be a signal that is continuous in time and represents some other quantity (referred to as amplitude or level of the signal). A digital signal may be a signal that is discrete in time and represents some other quantity as discrete values. The dynamic range of an ADC may be the ratio between the largest and smallest signal amplitudes that the ADC can convert without significant distortion. Dynamic range can be expressed in decibels (dB). A higher dynamic range means that the ADC can handle a wider range of input signal levels without distortion. The scale of an ADC can refer to the range of signal amplitudes that the ADC can convert into digital output values. The full-scale range (FSR) of an ADC may be the range between minimum and maximum signal amplitudes the ADC can convert.

ADCs can be used in various applications, including wireless receivers such as those used in Wi-Fi radios. Wi-Fi refers to the IEEE 802.11 family of technical standards ("802.11"), which define protocols for wireless local area networks (WLANs). The 802.11 family includes a series of half-duplex, over-the-air modulation techniques that use the same basic protocol. The 802.11 family employs carrier-sense multiple access with collision avoidance (CSMA/CA) where a WLAN radio listens to a channel for other users before transmitting each frame. Many standards in the 802.11 family use orthogonal frequency division multiplexing (OFDM) to control interference. Frequency division multiplexing (FDM) may be a technique where the available bandwidth is divided into multiple frequency bands, each carrying a separate signal. OFDM may be a type of FDM where the individual frequency bands (referred to as subcarriers) are made orthogonal to one another. Orthogonality means that the subcarriers are mathematically independent of one another, which allows the subcarriers to overlap in the frequency domain without causing interference. Other types of wireless applications use OFDM, including cellular networks (e.g., LTE/4G/5G networks).

A radio frequency (RF) blocker (also referred to as a blocker) may be an undesired signal, operating at radio frequency, that has a magnitude near or larger than a desired signal. An out-of-band blocker may be an RF blocker at a frequency far from the frequency of the desired signal (e.g., outside a defined frequency band for the desired signal). A receiver can use filters to eliminate out-of-band blockers. An in-band blocker may be an RF blocker at a frequency near the frequency of the desired signal (e.g., inside the defined frequency band for the desired signal). In-band blockers can produce interference at baseband in the receiver, which can be eliminated in the digital domain after conversion by the ADC.

The combination of multiple subcarriers used in OFDM, along with blockers, can lead to a high peak-to-average power ratio (PAPR). A receiver can handle signals and blockers that have high PAPR by utilizing a high dynamic range ADC. In conventional ADC design, improving dynamic range of the ADC can increase the circuit area and power consumption of the ADC. For example, a 6 dB improvement in dynamic range can require an ADC with four times the circuit area and four times the power consumption. It may be desirable in a receiver to improve handling of high PAPR signals/blockers with limited penalty in terms of circuit area and power consumption.

### SUMMARY

In an embodiment, a receiver includes a comparator configured to compare an analog signal and a reference signal. The receiver can include an analog-to-digital converter (ADC) having an input configured to receive the analog signal and an output configured to supply a digital signal. The receiver can include a first circuit configured to supply the analog signal to the input of the ADC, the first circuit configured to apply, under control by output of the comparator, a first operation to the analog signal. The receiver can include a second circuit configured to receive the digital signal from the output of the ADC, the second circuit configured to apply, under control of the output of the comparator, a second operation to the digital signal.

In another embodiment, an analog front-end (AFE) configured to down-convert a radio frequency (RF) signal to generate a first analog signal. The receiver can include a first circuit configured to generate a second analog signal. The receiver can include a multiplexer configured to supply an analog signal as one of the first analog signal or a second analog signal. The receiver can include an analog-to-digital converter (ADC) having an input configured to receive the analog signal and an output configured to supply a digital signal. The receiver can include a second circuit configured to supply the analog signal to the input of the ADC, the second circuit configured to apply, under control by output of the comparator, a first operation to the analog signal. The receiver can include a third circuit configured to receive the digital signal from the output of the ADC, the third circuit configured to apply, under control of the output of the comparator, a second operation to the digital signal.

In another embodiment, a method of analog-to-digital conversion in a receiver can include comparing, by a comparator, an analog signal and a reference signal. The method can include converting, by an analog-to-digital converter (ADC), the analog signal to a digital signal. The method can include applying, by a first circuit that supplies the analog signal to the ADC, a first operation to the analog signal under control of an output of the comparator. The method can include applying, by a second circuit that receives the digital signal from the ADC, a second operation to the digital signal under control of the output of the comparator.

### BRIEF DESCRIPTION OF THE DRAWINGS

Fig. 1 is a block diagram depicting a receiver according to some embodiments.
Fig. 2 is a block diagram depicting a receiver according to alternative embodiments.
Fig. 3 is a block diagram depicting an ADC path of a receiver according to some embodiments.
Fig. 4 is a block diagram depicting an ADC path of receiver according to further embodiments.
Fig. 5 is a flow diagram depicting a method of analog-to-digital conversion in a receiver according to some embodiments.
Fig. 6 is a flow diagram depicting a method of calibration of an ADC path in a receiver according to embodiments.

### DETAILED DESCRIPTION

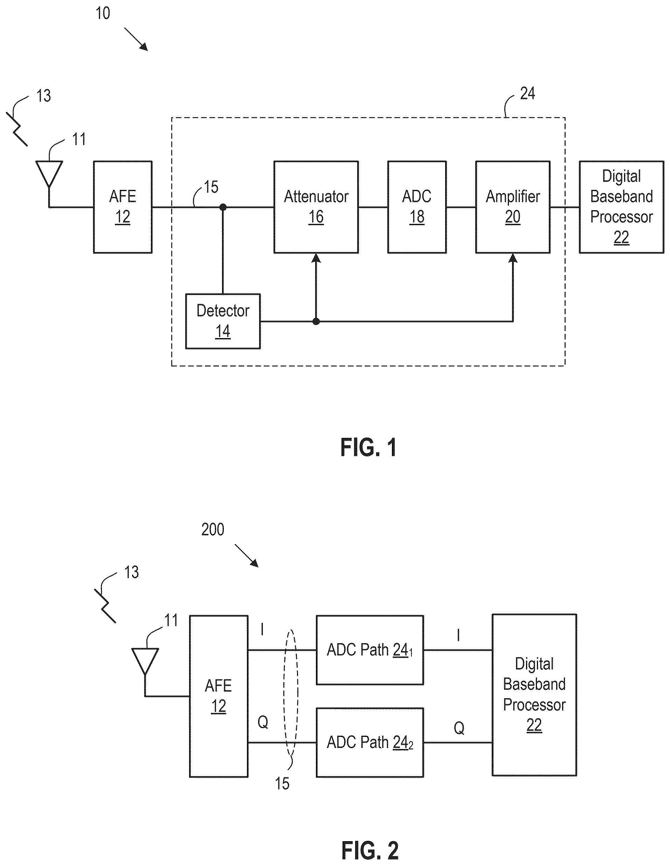

Fig. 1 is a block diagram depicting a receiver 10 according to some embodiments. A receiver may be a circuit that observes a signal propagating through a transmission medium. Receiver 10 can observe a radio frequency (RF) signal from a wireless transmission medium 13. An RF signal can be a signal having a frequency or frequencies in the RF spectrum. Receiver 10 can include an antenna 11, an analog front-end (AFE) 12, a detector 14, an attenuator 16, an analog-to-digital converter (ADC) 18, an amplifier 20, and a digital baseband processor 22. An antenna may be a device that converts an electric signal into radio waves (when transmitting) or radio waves into an electric signal (when receiving). Antenna 11 for receiver 10 can convert radio waves into an electric signal. The electric signal can have frequencies in the RF spectrum (e.g., an RF signal). An input of AFE 12 can be coupled to antenna 11. An AFE may be a circuit configured to condition an analog signal. AFE 12 can condition the RF signal, which can be an analog signal having an RF frequency.

In a communication system, a transmitter may be a circuit that transmits data through a transmission medium (e.g., wireless transmission medium 13). The transmitter can transmit data using digital modulation. Digital modulation may be when an analog signal (referred to as a carrier signal) is modulated by a digital signal. The changes in the carrier signal can be chosen from a finite set of symbols. Example digital modulations include binary phase-shift keying (BPSK), quadrature phase-shift keying (QPSK), and quadrature amplitude modulation (QAM). In some cases, the symbols can directly modulate the carrier signal. In other cases, the transmitter can employ FDM, such as OFDM. In OFDM, the symbols modulate orthogonal subcarrier signals, and the subcarrier signals are then mixed with a carrier frequency for transmission on a carrier signal. For example, IEEE 802.11ab/g/n/ac Wi-Fi standards employ OFDM using 64 subcarriers. Each Wi-Fi channel can be 20 MHz and each subcarrier can be spaced 312.4 kHz apart. Newer Wi-Fi standards, such as IEEE 802.11ax, use more subcarriers in orthogonal frequency division multiple access (OFDMA) (e.g., 256 subcarriers spaced 78.124 kHz apart in a 20 MHz channel). OFDMA allows specific groups of subcarriers to be dedicated to different devices. Other types of Wi-Fi standards, known or developed in the future, and other types of wireless systems (e.g., LTE/4G/5G cellular networks) can use OFDM or OFDMA with different numbers of subcarriers spaced within channels having different bandwidths.

In receiver 10, AFE 12 can condition the RF signal by converting the RF signal within a desired frequency band to an analog signal having a lower frequency (e.g., an operation referred to as down-conversion). Down-conversion may be a process of converting a signal from a higher frequency to a lower frequency. In some embodiment, AFE 12 can convert the RF signal to an analog signal at baseband. Baseband may be a range of frequencies occupied by a signal that is not modulated to higher frequencies, e.g., a frequency range starting from zero frequency to a maximum frequency. For example, some Wi-Fi standards can use a carrier signal at 2.4 GHz or 5 GHz. The 2.4 GHz Wi-Fi band can cover a 100 MHz range, which can be split into 14 channels of 20 MHz each. The 5 GHz Wi-Fi band can cover up to a 750 MHz range, which can be split into 24 channels of 20 MHz each. Some Wi-Fi standards can support channel bonding, which can provide greater-than 20 MHz channel widths. Other types of Wi-Fi standards, known or developed in the future, and other types of wireless systems (e.g., LTE/4G/5G cellular networks) can use different carrier frequencies, different bandwidths, and different channel sizes. The desired frequency band used by AFE 12 can be channel(s) of a selected frequency band, such as a 20 MHz channel in the 2.4 GHz Wi-Fi band.

AFE 12 can include various well-known circuits configured to perform down-conversion of the RF signal to the analog signal, e.g., an analog signal at baseband (referred to as the baseband signal). Such circuits can include, for example, filters, amplifiers, mixers, oscillators, and the like. AFE 12 can include a filter to select the desired frequency band (e.g., a bandpass filter) and reject out-of-band signals and noise (e.g., out-of-band blockers). In-band blockers can be down-converted and mixed with the desired signal in the baseband signal. For example, AFE 12 can be a super-heterodyne receiver that first converts the RF signal to an intermediate frequency (IF) signal, and then converts the IF signal to a baseband signal. An IF signal may be a signal with a frequency between RF and baseband. Alternatively, AFE 12 can be a homodyne receiver (also known as zero-IF receiver) that down-converts the RF signal directly to a baseband signal, e.g., direct conversion. In other examples, AFE 12 can be a low-IF receiver, where the RF signal can be down-converted to an IF signal and the IF signal is the output of the AFE. An IF signal may be a modulated carrier having an IF frequency. Thus, in some embodiments, AFE 12 can output an analog signal that is an IF signal. Output of AFE 12 is referred to below as an analog signal *15.*

In some embodiments, analog signal 15 output from AFE 12 can include an OFDM signal (e.g., the desired signal). Analog signal 15 can also include one or more in-band blockers. The OFDM signal can include modulated subcarriers, as described above. As noted above, the OFDM subcarriers and blockers in analog signal 15 can have a high PAPR. PAPR may be the power level of the highest instantaneous power compared to the average power level. However, the analog signal may spend a small percentage of time at peak power. For example, a typical analog output of an AFE having an OFDM signal and blockers might spend only 2% of the time for envelope levels that are between peak and 6 dB below peak. A signal envelope may be a curve outlining the signal's amplitude extremes.

ADC 18 can convert the analog signal to a digital signal. ADC 18 can be a flash ADC, a successive approximation register (SAR) ADC, and the like type Nyquist rate ADCs, each of which is known in the art. In some embodiments, ADC 18 can be a time-interleaved ADC. A time-interleaved ADC can be an ADC that achieves higher sampling rates by interleaving multiple ADC channels. Each ADC channel can operate at a fraction of the overall sampling rate, but when combined, produce a digital signal with a higher effective sampling rate. Each ADC channel can include an ADC referred to as a "unit-ADC." For example, a time-interleaved ADC can include four ADC channels, that is, four unit-ADCs. The unit-ADCs can be flash ADCs, SAR ADCs, etc.

To prevent signal distortion, the peaks of analog signal 15 should stay within the FSR of ADC 18. ADC 18 can be designed with a dynamic range and FSR that accommodates the peaks of analog signal 15. However, as described above, this can increase circuit area and power consumption of the ADC. In some embodiments, rather than directly increasing the FSR of ADC 18 using circuit design of ADC 18, receiver 10 includes attenuator 16 between AFE 12 and ADC 18. An attenuator may be a circuit that reduces the amplitude of a signal. Attenuator 16 can selectively reduce the amplitude of analog signal 15 around the peaks so that the peaks are not clipped by ADC 18. That is, if analog signal 15 is supplied to ADC 18 without attenuator 16, then the peaks of the analog signal 15 may be outside the FSR of ADC 18 and could be clipped. However, with attenuator 16, the peaks can be reduced and fit within the FSR of ADC 18. Attenuator 16 can apply a first operation to analog signal 15 based on output of detector 14. The first operation can be reducing amplitude of analog signal 15 or passing analog signal 15. Passing a signal may be an operation with no intentional signal manipulation. The pass operation can result in some parasitic amplitude adjustment, which can be compensated for by calibration as discussed below. A detector may be a circuit that detects condition(s) of an input signal. The input of detector 14 can receive analog signal 15 output from AFE 12. Detector 14 can be configured to detect when the amplitude of analog signal 15 falls outside the FSR of ADC 18. When detector 14 detects the amplitude of analog signal 15 falling outside the FSR of ADC 18, detector 14 can control attenuator 16 to reduce amplitude of analog signal 15. Otherwise, detector 14 can control attenuator 16 to pass analog signal 15. Attenuator 16 can reduce amplitude of analog signal 15 by scaling or shifting operations, as discussed further below.

A parameter of an ADC is the ratio between full-scale (FS) of the ADC and the noise floor of the ADC. The FS of an ADC may be extreme values of the FSR (ceiling and floor values). The ratio of FS to noise floor can be measured in dBFS/Hz. Improving this ratio in an ADC can improve the ADC's capability of handling blockers. For example, when placing a constant 6 dB attenuation in front of the ADC, both the FS and the noise of the combined attenuator/ADC is 6 dB higher. Hence, the dBFS/Hz remains the same. If, however, the 6 dB attenuation in front of the ADC is switched on dynamically only when analog signal 15 is 6 dB above the FS of the ADC, the combined attenuator/ADC will have a 6 dB higher FS, but the noise floor will not be significantly affected. This is because, as discussed above, the peaks in analog signal 15 comprising the OFDM signal and blocker(s) are rare. The noise floor will be the weighted average of the noise without attenuation (e.g., 0 dB attenuation) and the noise with attenuation (e.g., 6 dB attenuation). For a typical OFDM signal that spends only 2% of the time between peak and 6 dB below peak power, the weighted average of the noise floor can be around a 0.23 dB increase.

In some embodiments, analog signal 15 comprises an OFDM signal and blocker(s) and attenuator 16 can selectively reduce the amplitude of analog signal 15 by an amount, such as a 6 dB, when analog signal 15 is 6 dB above FS of ADC 18. Other amplitude reduction amounts can be used (e.g., reduction by X dB when analog signal 15 is X dB above FS of ADC 18, where X is a variable). Analog signal 15 can include other types of desired signals that spend some small percentage of time between peak and X dB below peak power. Attenuator 16 and detector 14 can be implemented using circuits that process analog signals. Example circuits are described below.

Receiver 10 can include amplifier 20. An amplifier may be a circuit that increases the amplitude of a signal. An input of amplifier 20 can be coupled to an output of ADC 18. Amplifier 20 can selectively increase the amplitude of the digital signal output from ADC 18 based on the output of detector 14. That is, when detector 14 controls attenuator 16 to reduce amplitude of analog signal 15, detector 14 concurrently controls amplifier 20 to increase amplitude the digital signal output from ADC 18. Amplifier 20 can function to reverse the operation of attenuator 16. For example, attenuator 16 can scale analog signal 15 with a gain of either 1.0 or 0.5. When analog signal 15 is within the FSR of ADC 18, detector 14 can control attenuator 16 to scale analog signal 15 with a gain of 1.0 (e.g., pass the analog signal). In such case, detector 14 can control amplifier 20 to scale the digital signal with a gain of 1.0 (e.g., pass the digital signal). When analog signal 15 is outside the FSR of ADC 18, detector 14 can control attenuator 16 to scale analog signal 15 with a gain of 0.5. In such case, amplifier 20 can be controlled to scale the digital signal with a gain of 2.0. Amplifier can be implemented using circuits that process digital signals. Example circuits are described below. Examples with the reduction operation is shifting instead of scaling are also described below.

An output of amplifier 20 can be coupled to an input of digital baseband processor 22. Digital baseband processor 22 can be a circuit that processes digital signals, such as a circuit that demodulates the digital signal generated by ADC 18. Circuits for digital demodulation of a signal, such as a signal with BPSK, QPSK, or QAM modulated OFDM subcarriers, are well known in the art.

In the example of Fig. 1, receiver 10 includes an ADC path 24. An ADC path may include circuits for ADC conversion. ADC path 24 can include detector 14, attenuator 16, ADC 18, and amplifier 20. Some types of digital modulation can employ both in-phase and quadrature carriers/subcarriers, such as QPSK and QAM. A quadrature carrier/subcarrier may be a signal 90 degrees out-of-phase with respect to an in-phase carrier/subcarrier. The transmitter can combine the in-phase carrier/subcarriers and quadrature carrier/subcarriers at transmission into wireless medium 13. In such case, AFE 12 can output both an in-phase analog signal and a quadrature analog signal using IQ down-converting as is known in the art. ADC path 24 as shown in Fig. 1 can process one of an in-phase analog signal or a quadrature analog signal (e.g., for a digital demodulation that does not use both in-phase and quadrature components, such as BPSK).

Fig. 2 is a block diagram depicting a receiver 200 according to alternative embodiments. Receiver 200 is similar to receiver 10 with the exception of including ADC paths 24₁ and 24₂. Each ADC path 24₁, 24₂ can be identical to ADC path 24 in receiver 10. AFE 12 can output both in-phase (I) and quadrature (Q) analog signals. ADC path 24₁ can process the in-phase analog signal. ADC path 24₂ can process the quadrature analog signal. Digital baseband processor 22 can receive both in-phase and quadrature digital signals from ADC path 24₁ and ADC path 24₂, respectively, and perform digital demodulation. Each of ADC path 24₁ and 24₂ can operate as described above for ADC path 24.

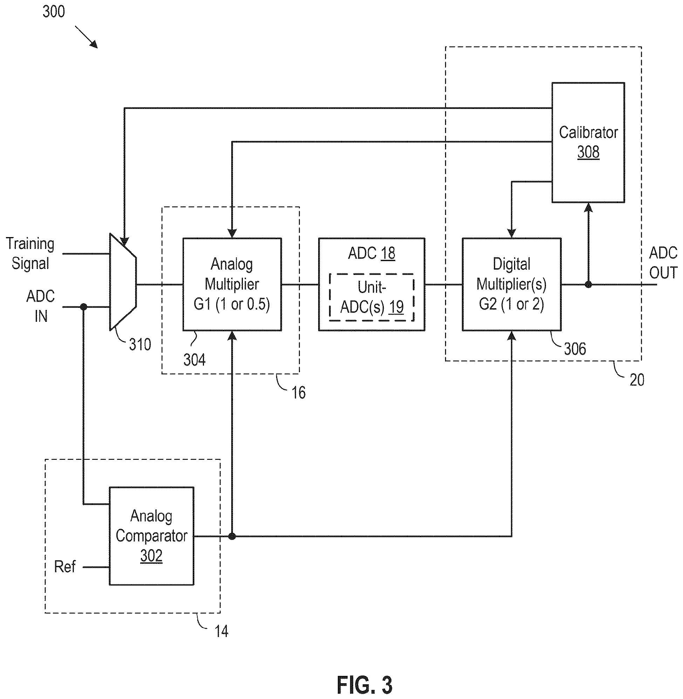

Fig. 3 is a block diagram depicting an ADC path 300 of receiver 10 according to some embodiments. ADC path 24 in receiver 10 can be implemented as shown in Fig. 3. Each of ADC paths 24₁ and 24₂ in receiver 200 can be implemented as shown in Fig. 3. In the embodiment, detector 14 can include an analog comparator 302. Attenuator 16 can include an analog multiplier 304. Amplifier 20 can include one or more digital multipliers 306 and a calibrator 308. ADC path 300 includes an input (ADC IN) and an output (ADC OUT). The input can be analog signal 15 (e.g., either an in-phase analog signal or quadrature analog signal). Analog signal 15 at the input of ADC path 300 has an envelope with a positive maximum amplitude and a negative minimum amplitude. For example, analog signal 15 can be a voltage signal having an amplitude that varies between +V and -V. This can be implemented using single-ended signaling, where the voltage on one conductor varies between +V and -V with respect to electrical ground. Electrical ground may be a reference voltage for all voltages in the receiver (e.g., 0 V). Alternatively, AFE 12 can output analog signal 15 using differential signaling. In such case, voltage signals on the two conductors can be 180 degrees out-of-phase (referred to as the positive voltage signal and the negative voltage signal) and the difference in voltage between two signals can vary between +V and -V.

A comparator can be a circuit that compares inputs and generates an output. An analog comparator can be a circuit that compares analog inputs and generates an analog output. Analog comparator 302 can compare the absolute value of analog signal 15 with a reference signal (e.g., a constant voltage). The output of comparator 302 can be a signal that is one of two voltages corresponding to two states. In a first state (a pass state), attenuator 16 can pass analog signal 15 to the input to ADC 18. In a second state (a scaling state), scaling can be applied to analog signal 15 input to the ADC 18. The reference signal can be set to determine when scaling is applied (e.g., when analog signal 15 signal is some dB above or below FS of ADC 18, such as 6 dB above or below FS). The output of analog comparator 302 can be coupled to analog multiplier 304 and digital multiplier(s) 306.

Analog multiplier 304 can be coupled between the input of ADC path 300 and the input of ADC 18. An analog multiplier may be a circuit that multiplies input analog signals. For analog multiplier 304, analog signal 15 can be one input analog signal, and a constant analog signal (e.g., a constant DC voltage) can be another input analog signal. Analog multiplier 304 can have two states. In the first state (pass state), analog multiplier 304 can multiply analog signal 15 by a factor of one. Thus, the amplitude of analog signal 15 is not reduced (ideally) in the pass state. In the second state (scaling state), analog multiplier 304 can multiply analog signal 15 by a fractional factor. For example, in the scaling state, analog multiplier 304 can multiply analog signal 15 by a factor of 0.5. Other factors can be used. Thus, in the scaling state, the amplitude of analog signal 15 can be divided by two.

In some embodiments, ADC path 300 can include a multiplexer 310. The output of multiplexer 310 can be coupled to the input of analog multiplier 304. The first input of multiplexer 310 can be the ADC input (ADC IN). The second input of multiplexer 310 can be a training signal. The training signal can be used during calibration of ADC path 300 and is discussed below. Multiplexer 310 can be any type of analog circuit for switching between two signal sources.

For clarity, assume ADC 18 is not a time-interleaved ADC. In such an embodiment, amplifier 20 can include a single digital multiplier 306. A digital multiplier may be a circuit that multiplies digital signals. For digital multiplier 306, one input signal is the digital signal output from ADC 18, and another input signal is a digital signal representing a constant value. Digital multiplier 306 can have two states. In the first state (pass state), digital multiplier 306 can multiply the digital signal by a factor of one. Thus, the amplitude of the digital signal does not change in the pass state. In the second state (scaling state), digital multiplier 306 can multiply the digital signal by a factor that is the reciprocal of the factor used by analog multiplier 304. For example, in the scaling state, digital multiplier 306 can multiply the digital signal by a factor of two.

Thus, ADC path 300 can be in two possible states: the pass state or the scaling state. In this multiplier-based embodiment, both states can have a combined gain of one. In the pass state, both analog multiplier 304 and digital multiplier 306 can multiply their respective input signals by a factor of one. In the scaling state, analog multiplier 304 can multiply analog signal 15 by a fractional factor and digital multiplier 306 can multiply the digital signal by a reciprocal of that fractional factor (e.g., 0.5 and two, respectively). After calibration by calibrator 308, the two states can have the combined gain of one (within a tolerance of the calibration). Analog comparator 302 can decide when to switch between states. Analog comparator 302 is not required to be precise when deciding the duty-cycle between states. The signal integrity can be maintained since the combined gain in the two states can be identical.

Analog multiplier 304 can be an analog circuit that is subject to variations, such as process, voltage, and temperature (PVT) variations. A calibrator may be a circuit that performs calibration. Calibration may be to adjust within a desired precision to achieve a particular function. Calibrator 308 can operate to compensate for variations in analog multiplier 304 to maintain the combined gain of one across both pass and scaling states. Calibrator 308 can include an input coupled to the output of digital multiplier 306 that supplies the digital signal. Calibrator 308 can include an output coupled to a control input of digital multiplier 306, an output coupled to a control input of analog multiplier 304, and an output coupled to a control input of multiplexer 310.

In operation, calibrator 308 can control multiplexer 310 to select the training signal. The training signal can be such that analog comparator 302 selects the pass state. The training signal can be a constant DC signal, a sinusoidal signal, or any type of signal having a constant or near constant root mean square (RMS) value (e.g., even a noise signal with constant or near constant RMS value). Calibrator 308 can observe the digital signal output from digital multiplier 306 in the pass state and measure an error in the combined gain, which should be unity gain. Since the amplitude of the training signal is known, the expected amplitude of the digital signal is known and any difference from the expected value can be used to determine the error in the combined gain in the pass state. Calibrator 308 can determine a factor for use by digital multiplier 306 in the pass state to compensate for the error. Thereafter, calibrator 308 can force analog multiplier 304 to operate in the scaling state. Calibrator 308 can observe the digital signal output from digital multiplier 306 in the scaling state and measure the error in combined gain, which should be unity gain. Since the amplitude of the training signal is known, the expected amplitude of the digital signal is known and any difference from the expected value can be used to determine the error in combined gain in the scaling state. Calibrator 308 can determine a factor for use by digital multiplier 306 in the scaling state to compensate for the error. Thus, calibrator 308 can supply both factors to digital multiplier 306 for the pass and scaling states to achieve a combined gain of one (unity gain) across both states within a precision of calibrator 308. Calibrator 308 can be implemented using circuits performing hardware functions, circuits executing software functions, or a combination thereof.

In some embodiments, ADC 18 can be a time-interleaved ADC. In such an embodiment, ADC 18 can include multiple unit-ADCs 19. In such an embodiment, amplifier 20 can include a digital multiplier 306 for each unit-ADC 19 (e.g., for each channel of ADC 18). That is, ADC 18 can output multiple digital signals, each of which can be input to a separate one of multiple digital multipliers 306. Calibrator 308 can observe the digital signals from each of the digital multipliers 306. Calibrator 308 can function as described above and generate factors for use by each digital multiplier 306 in both the pass and scaling states.

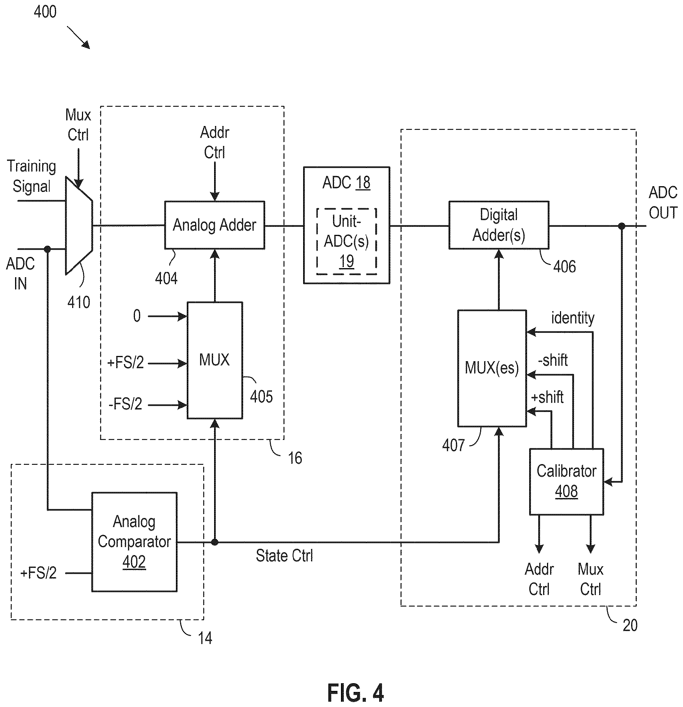

Fig. 4 is a block diagram depicting an ADC path 400 of receiver 10 according to some embodiments. ADC path 24 in receiver 10 can be implemented as shown in Fig. 4. Each of ADC paths 24₁ and 24₂ in receiver 200 can be implemented as shown in Fig. 4. In the embodiment, detector 14 can include an analog comparator 402. Attenuator 16 can include an analog adder 404 and a multiplexer 405. Amplifier 20 can include one or more digital adders 406, one or more multiplexers 407, and a calibrator 408. ADC path 400 includes an input (ADC IN) and an output (ADC OUT). The input can be analog signal 15 (either an in-phase analog signal or a quadrature analog signal). Analog signal 15 at the input of ADC path 400 has an envelope with a positive maximum amplitude and a negative minimum amplitude. For example, analog signal 15 can be a voltage signal having an amplitude that varies between +V and -V. This can be implemented using single-ended signaling, where the voltage on one conductor varies between +V and -V with respect to electrical ground. Alternatively, AFE 12 can output analog signal 15 using differential signaling. In such case, voltage signals on the two conductors can be 180 degrees out-of-phase (referred to as the positive voltage signal and the negative voltage signal) and the difference in voltage between two signals can vary between +V and -V.

Analog comparator 402 can compare analog signal 15 with a reference signal (e.g., a constant voltage). The constant voltage can be, for example, FS/2 where FS is the positive full-scale of ADC 18. The output of analog comparator 402 can be a signal that is one of three states (shown as state ctrl). In a first state (pass state), there is no amplitude shift of analog signal 15 input to ADC 18. Analog comparator 402 can select the pass state when amplitude of analog signal 15 is between -FS/2 and +FS/2. In a second state (subtract state), a negative addend can be summed with analog signal 15 when the amplitude of analog signal 15 is above +FS/2. Analog comparator 402 can select the subtract state when amplitude of analog signal 15 is greater than +FS/2. In a third state (add state), a positive addend can be summed with analog signal 15 when the amplitude of analog signal 15 is below -FS/2. Analog comparator 402 can select the add state when amplitude of analog signal 15 is less than -FS/2. In general, attenuator 16 can sum a positive or negative addend with analog signal 15 when |amplitude| > FS/2 and can pass analog signal 15 when |amplitude| < FS/2. Hence, analog comparator 402 can compare the absolute value of analog signal 15 with the voltage FS/2. In case of the condition |amplitude| > FS/2, analog comparator 402 can select between the subtract state and add state based on the polarity of analog signal 15 (e.g., if positive polarity then subtract state, if negative polarity then add state). The output of analog comparator 402 can control multiplexer 405 and multiplexer(s) 407.

Analog adder 404 can be coupled between the input of ADC path 400 and the input of ADC 18. An analog adder may be a circuit that adds analog signals. For analog adder 404, analog signal 15 can be one input analog signal, and a constant value (constant voltage) can be another input analog signal. Multiplexer 405 can supply the constant voltage input to analog adder 404. Multiplexer 405 can select among constant voltages of zero, +FS/2, and -FS/2 based on the state control output from analog comparator 402. If the state control indicates the ipass state, multiplexer 405 can select the constant zero voltage as input to analog adder 404. If the state control indicates the subtract state, multiplexer 405 can select the constant -FS/2 voltage as input to analog adder 404. If the state control indicates the add state, multiplexer 405 can select the constant +FS/2 voltage as input to analog adder 404.

In some embodiments, ADC path 400 can include a multiplexer 410. The output of multiplexer 410 can be coupled to the input of analog adder 404. A first input of multiplexer 410 can be the ADC input (ADC IN). A second input of multiplexer 410 can be a training signal. The training signal can be used during calibration of ADC path 400 and is discussed below. Multiplexer 410 can be any type of analog circuit for switching between two signal sources.

For clarity, assume ADC 18 is not a time-interleaved ADC. In such an embodiment, amplifier 20 can include a single digital adder 406 and single multiplexer 407. A digital adder may be a circuit that adds digital signals. For digital adder 406, one input signal is the digital signal output from ADC 18, and another input signal is a constant value. Multiplexer 407 can supply the constant voltage input to digital adder 406. Multiplexer 407 can select among constant voltages of identity, -shift, and +shift based on the state control output from analog comparator 402. If the state control indicates the pass state, multiplexer 407 can select the constant identity voltage as input to digital adder 406. If the state control indicates the subtract state, multiplexer 407 can select the constant +shift voltage as input to digital adder 406. If the state control indicates the add state, multiplexer 407 can select the constant -shift voltage as input to digital adder 406. Ideally, +shift can be set to +FS/2, -shift can be set to -FS/2, and identity can be set to zero. As described below, +shift, -shift, and identity can be set by calibrator 408 to address variations in analog adder 404.

Thus, ADC path 400 can be in three possible states: the pass state, the add state, or the subtract state. Each state can have a combined shift of zero. In the pass state, analog adder 404 can add zero to analog signal 15 and digital adder 406 can add identity to the digital signal, which can be calibrated to compensate for any deviation from zero by analog adder 404. In the subtract state, analog adder 304 can add -FS/2 to analog signal 15 and digital adder 306 can add +shift to the digital signal, which can be calibrated as the additive inverse to -FS/2. In the add state, analog adder 304 can add FS/2 to analog signal 15 and digital adder 306 can add -shift to the digital signal, which can be calibrated as the additive inverse to FS/2. After calibration by calibrator 308, the states can have a combined shift of zero (within a tolerance of the calibration). Analog comparator 402 can decide when to switch between states. Analog comparator 402 is not required to be precise when deciding the duty-cycle between states. The signal integrity can be maintained since the combined gain in the states can be identical.

Analog adder 404 can be an analog circuit that is subject to variations, such as PVT variations. Calibrator 408 can operate to compensate for variations in analog adder 404 to maintain the combined shift of zero across the states. Calibrator 408 can include an input coupled to the output of digital adder 406 that supplies the digital signal. Calibrator 408 can include outputs that supply identity, +shift, and -shift, an output coupled to a control input of analog adder 404, and an output coupled to a control input of multiplexer 410.

In operation, calibrator 408 can control multiplexer 410 to select the training signal. The training signal can be any type of training signal discussed above (e.g., a constant DC signal). The training signal can be such that analog comparator 402 selects the pass state. Calibrator 408 can observe the digital signal output from digital adder 406 in the pass state and measure an error in the combined gain. Since the amplitude of the training signal is known, the expected amplitude of the digital signal is known and any difference from the expected value can be used to determine the error in the combined shift in the identity state. Calibrator 308 can determine a value for identity to use by digital adder 406 in the pass state to compensate for the error.

Thereafter, calibrator 408 can force analog adder 404 to operate in the subtract state (adding -FS/2). Calibrator 408 can observe the digital signal output from digital multiplier 306 in the subtract state and measure the error in the combined shift. Since the amplitude of the training signal is known, the expected amplitude of the digital signal is known and any difference from the expected value can be used to determine the error in the combined shift in the subtract state. Calibrator 408 can determine a value +shift for use by digital adder 406 in the subtract state to compensate for the error.

Calibrator 408 can force analog adder 404 to operate in the add state (adding +FS/2). Calibrator 408 can observe the digital signal output from digital multiplier 406 in the add state and measure the error in the combined shift. Since the amplitude of the training signal is known, the expected amplitude of the digital signal is known and any difference from the expected value can be used to determine the error in the combined shift in the add state. Calibrator 408 can determine a value -shift for use by digital adder 406 in the too-low state to compensate for the error.

Thus, calibrator 408 can supply addends to digital multiplier 306 for the pass state, subtract state, and add state to achieve a combined shift of zero across all states within a precision of calibrator 408. Calibrator 408 can be implemented using circuits, software, or a combination thereof.

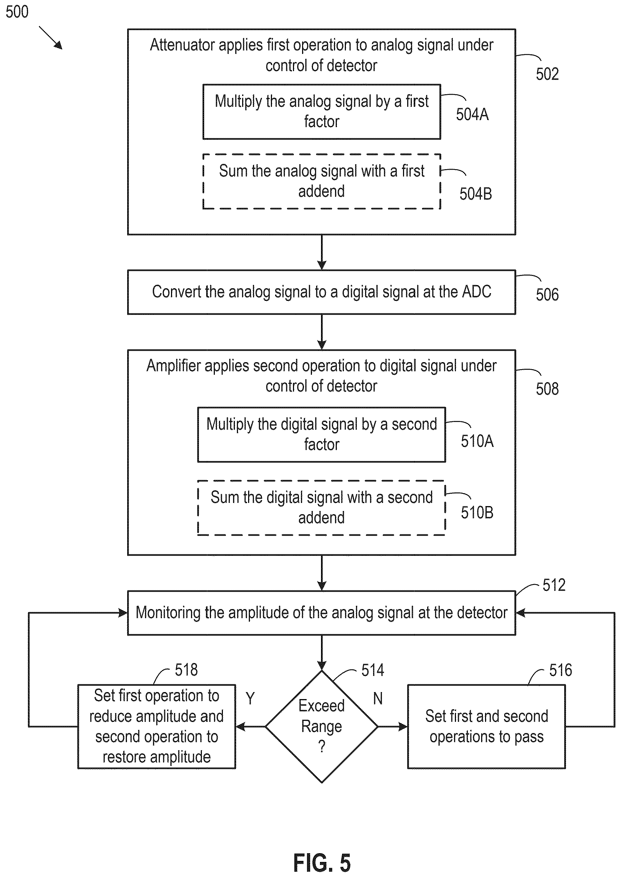

Fig. 5 is a flow diagram depicting a method 500 of analog-to-digital conversion in a receiver according to some embodiments. Method 500 begins at step 502, where attenuator 16 applies a first operation to analog signal 15 under control of detector 14. In some embodiments, attenuator 16 can include analog multiplier 304. In such an embodiment, step 502 can include a step 504A, where analog multiplier 304 can multiply the analog signal by a first factor. In other embodiments, attenuator 16 can include analog adder 404. In such an embodiment, step 502 can include a step 504B instead of step 504A. In step 504B, analog adder 404 can sum the analog signal with a first addend. Method 500 proceeds from step 502 to step 506. At step 506, ADC 18 can convert the analog signal as output from attenuator 16 into a digital signal.

Method 500 proceeds from step 506 to step 508. At step 508, amplifier 20 can apply a second operation to the digital signal under control of detector 14. In some embodiments, amplifier 20 can include digital multiplier 306 corresponding to analog multiplier 304. In such an embodiment, step 508 can include a step 510A, where digital multiplier 306 can multiply the digital signal by a second factor. The second factor can be a reciprocal of the first factor. In other embodiments, amplifier 20 can include digital adder 406. In such an embodiment, step 508 can include a step 510B instead of step 510A. In step 510B, digital adder 406 can sum the digital signal with a second addended. The second addend can be the additive inverse of the first addend.

Method 500 proceeds from step 508 to step 512. At step 512, detector 14 can monitor the amplitude of the analog signal. At step 514, detector 14 can determine if the amplitude of the analog signal exceeds a range. If is within the range, method 500 proceeds to step 516, where detector 14 can set the first and second operations to be pass operations. That is, attenuator 16 can pass the analog signal and amplifier 20 can pass the digital signal. For the pass operation, detector 14 can set the first factor and the second factor to be a multiplicative identity (e.g., a factor of one). Alternatively, for a pass operation, detector 14 can set the first addend and the second addend to be the additive identity (e.g., an addend of zero).

If the amplitude of the analog signal exceeds the range, method 500 proceeds to step 518, where detector 14 can set attenuator 16 to reduce the amplitude of the analog signal and set amplifier 20 to restore the amplitude of the digital signal. The amplitude of a signal that has been reduced can be restored by performing a second operation that is the inverse of a first operation that reduced the amplitude. For example, attenuator 16 can perform the first operation of multiplying the analog signal by the first factor that is less than one and amplifier 20 can perform the second operation that is the inverse of the first operation, namely, multiplying the digital signal by the second factor being a reciprocal of the first factor. In another example, attenuator 16 can perform the first operation of summing the analog signal with the first added and amplifier 20 can perform the second operation that is the inverse of the first operation, namely, summing the digital signal with the second addend being the additive inverse of the first addend.

In embodiments described above, detector 14 can be analog comparator 302 or 402. The analog comparator compares the absolute value of analog signal 15 against a reference. In examples, the reference can be FS/2 for example. In such case, the range can be defined as (-FS/2, FS/2) or [-FS/2, FS/2]. Other ranges can be defined and used by detector 14 at step 514.

In embodiments described above, the common gain of the ADC path can be set to a third gain that is constant across the different states. In the examples, this third gain can be unity gain (e.g., a gain of one). Thus, regardless of the current state of analog signal 15, the common gain, e.g., a combination of the first gain and the second gain, can be a desired third gain (e.g., unity gain).

In embodiments described above, when the amplitude of analog signal 15 is within the defined range, then no attenuation is applied (non-attenuation state). In such case, the first gain of attenuator 16 and the second gain of amplifier 20 can be set to unity gain. In embodiments described above, when the amplitude of analog signal 15 is outside the defined range, then attenuation is applied (an attenuation state). In such case, the first gain of attenuator 16 can be less than one and the second gain of amplifier 20 can be more than one. For example, if multipliers are used (e.g., Fig. 3), the second gain can be a reciprocal of the first gain. In another example, if adders are used (e.g., Fig. 4), the second gain can be the additive inverse of the first gain.

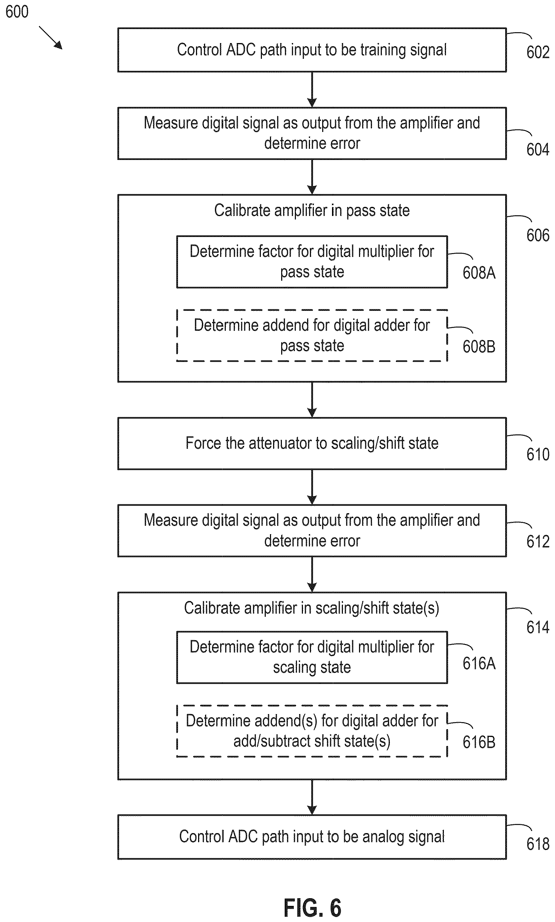

Fig. 6 is a flow diagram depicting a method 600 of calibration of an ADC path in a receiver according to embodiments. Method 600 can be performed by a calibrator, such as calibrator 308 or calibrator 408. Method 600 begins at step 602, where the calibrator controls the ADC path input to be a training signal. At step 604, the calibrator measures the digital signal output from amplifier 20 and determines an error. As described above, the training signal can be such that its amplitude is within the range of detector and detector 14 selects pass state. The calibrator can determine the error of the amplitude of the digital signal with respect to the expected amplitude given the training signal. At step 606, the calibrator can calibrate amplifier 20 in the pass state. For example, if amplifier 20 includes a digital multiplier, then step 606 can include a step 608A, where the calibrator determines a factor for the digital multiplier in the pass state. If amplifier 20 includes a digital adder, then step 606 can include a step 608B instead of step 608A. In step 608B, the calibrator can determine an addend for the digital adder in the pass state.

Method 600 can proceed to step 610 from step 606. At step 610, the calibrator can force attenuator 16 into a scaling/shift state. At step 612, the calibrator can measure the digital signal output from amplifier 20 and determine the error. At step 614, the calibrator can calibrate amplifier 20 in a scaling/shift state. For example, if amplifier 20 includes a digital multiplier, then step 614 can include a step 616A, where the calibrator determines a factor for the digital multiplier in the scaling state. If amplifier 20 includes a digital adder, then step 614 can include a step 616B instead of step 616A. In step 616B, the calibrator can determine addend(s) for the digital adder in add/subtract shift state(s). Method 600 can proceed to step 618 from step 614. At step 618, the calibrator can control the ADC path input to be analog signal 15 output from AFE 12. The calibrator can repeat method 600 anytime calibration is to be performed.

While some processes and methods having various operations have been described, one or more embodiments also relate to a device or an apparatus for performing these operations. The apparatus may be specially constructed for required purposes, or the apparatus may be a general-purpose computer selectively activated or configured by a computer program stored in the computer. Various general-purpose machines may be used with computer programs written in accordance with the teachings herein, or it may be more convenient to construct a more specialized apparatus to perform the required operations.

As used herein, the phrase "at least one of" preceding a series of items, with the term "and" or "or" to separate any of the items, modifies the list as a whole, rather than each member of the list (i.e., each item). The phrase "at least one of" does not require selection of at least one of each item listed; rather, the phrase allows a meaning that includes at least one of any one of the items, and/or at least one of any combination of the items. By way of example, the phrases "at least one of A, B, and C" or "at least one of A, B, or C" each refer to only A, only B, or only C; and/or any combination of A, B, and C. In instances where it is intended that a selection be of "at least one of each of A, B, and C ," or alternatively, "at least one of A, at least one of B, and at least one of C," it is expressly described as such.

It will be understood that, although the terms "first," "second," etc. may be used herein to describe various elements, these elements should not be limited by these terms. These terms are only used to distinguish one element from another. For example, a first element could be termed a second element, and, similarly, a second element could be termed a first element, without departing from the scope of the present disclosure.

Although one or more embodiments of the present invention have been described in some detail for clarity of understanding, certain changes may be made within the scope of the claims. Accordingly, the described embodiments are to be considered as illustrative and not restrictive, and the scope of the claims is not to be limited to details given herein but may be modified within the scope and equivalents of the claims. In the claims, elements and/or steps do not imply any particular order of operation unless explicitly stated in the claims.

Boundaries between components, operations, and data stores are somewhat arbitrary, and particular operations are illustrated in the context of specific illustrative configurations. Other allocations of functionality are envisioned and may fall within the scope of the invention. In general, structures and functionalities presented as separate components in exemplary configurations may be implemented as a combined structure or component. Similarly, structures and functionalities presented as a single component may be implemented as separate components. These and other variations, additions, and improvements may fall within the scope of the appended claims.

The following are further embodiments of the invention:
1. A receiver, comprising:
   a comparator configured to compare an analog signal and a reference signal;
   an analog-to-digital converter (ADC) having an input configured to receive the analog signal and an output configured to supply a digital signal;
   a first circuit configured to supply the analog signal to the input of the ADC, the first circuit configured to apply, under control by output of the comparator, a first operation to the analog signal; and
   a second circuit configured to receive the digital signal from the output of the ADC, the second circuit configured to apply, under control of the output of the comparator, a second operation to the digital signal.
2. The receiver of embodiment 1, wherein the output of the comparator is a first state in response to an amplitude of the analog signal exceeding a range determined by the reference signal, wherein the first operation, in response to the output of the comparator being in the first state, is configured to reduce the amplitude of the analog signal, and wherein the second operation, in response to the output of the comparator being in the first state, is configured to increase the amplitude of the digital signal.
3. The receiver of embodiment 2, wherein the output of the comparator is a second state in response to the amplitude of the analog signal being within the range, wherein the first operation, in response to the output of the comparator being in the second state, is configured to pass the analog signal, and wherein the second operation, in response to the output of the comparator being in the second state, is configured to pass the digital signal.
4. The receiver of embodiment 1, wherein the first circuit comprises an analog multiplier and the first operation is multiplication of the analog signal by a first factor, and wherein the second circuit comprises a digital multiplier and the second operation is multiplication of the digital signal by a second factor, the second factor being a reciprocal of the first factor.
5. The receiver of embodiment 3, further comprising a calibrator configured to adjust the second factor in response to measuring the first factor from the digital signal.
6. The receiver of embodiment 1, wherein the first circuit comprises an analog adder and the first operation is summation of the analog signal with a first addend, and wherein the second circuit comprises a digital adder and the second operation is summation of the digital signal with a second addend, the second addend being an additive inverse of the first addend.
7. The receiver of embodiment 5, further comprising a calibrator configured to adjust the second addend in response to measuring the first addend from the digital signal.
8. A receiver, comprising:
   an analog front-end (AFE) configured to down-convert a radio frequency (RF) signal to generate a first analog signal;
   a first circuit configured to generate a second analog signal;
   a multiplexer configured to supply an analog signal as one of the first analog signal or the second analog signal;
   a comparator configured to compare the analog signal and a reference signal;
   an analog-to-digital converter (ADC) having an input configured to receive the analog signal and an output configured to supply a digital signal;
   a second circuit configured to supply the analog signal to the input of the ADC, the second circuit configured to apply, under control by output of the comparator, a first operation to the analog signal; and
   a third circuit configured to receive the digital signal from the output of the ADC, the third circuit configured to apply, under control of the output of the comparator, a second operation to the digital signal.
9. The receiver of embodiment 8, wherein the output of the comparator is a first state in response to an amplitude of the analog signal exceeding a range determined by the reference signal and a second state in response to the amplitude of the analog signal being within the range, wherein the first operation is configured to reduce the amplitude the analog signal in response to the output of the comparator being in first state and to pass the analog signal in response to the output of the comparator being in the second state, and wherein the second operation is configured to increase the amplitude of the digital signal in response to the output of the comparator being in the first state and pass the digital signal in response to the output of the comparator being in the second state.
10. The receiver of embodiment 9, wherein the range is between -FS/X and +FS/X, where FS is a full-scale of the ADC and X is greater than or equal to one.
11. The receiver of embodiment 8, wherein the first analog signal comprises an orthogonal frequency division multiplexing (OFDM) signal.
12. The receiver of embodiment 8, wherein the second analog signal comprises a training signal, and wherein the receiver further comprises a calibrator configured to: control the multiplexer to select between the first analog signal and the second analog signal; and calibrate the second operation in response to measuring the first operation from the digital signal.
13. The receiver of embodiment 8, wherein the second circuit comprises an analog multiplier and the first operation is multiplication of the analog signal by a first factor, and wherein the third circuit comprises a digital multiplier and the second operation is multiplication of the digital signal by a second factor, the second factor being a reciprocal of the first factor.
14. The receiver of embodiment 8, wherein the second circuit comprises an analog adder and the first operation is summation of the analog signal with a first addend, and wherein the third circuit comprises a digital adder and the second operation is summation of the digital signal with a second addend, the second addend being an additive inverse of the first addend.
15. A method of analog-to-digital conversion in a receiver, comprising:
   comparing, by a comparator, an analog signal and a reference signal;
   converting, by an analog-to-digital converter (ADC), the analog signal to a digital signal;
   applying, by a first circuit that supplies the analog signal to the ADC, a first operation to the analog signal under control of an output of the comparator; and
   applying, by a second circuit that receives the digital signal from the ADC, a second operation to the digital signal under control of the output of the comparator.
16. The method of embodiment 15, wherein the output of the comparator is a first state in response to an amplitude of the analog signal exceeding a range determined by the reference signal, wherein the first operation, in response to the output of the comparator being in the first state, reduces the amplitude of the analog signal, and wherein the second operation, in response to the output of the comparator being in the first state, increases the amplitude of the digital signal.
17. The method of embodiment 15, wherein the first circuit comprises an analog multiplier and the second circuit comprises a digital multiplier, wherein the step of applying the first operation comprises multiplying, by the analog multiplier, the analog signal by a first factor, and wherein the step of applying the second operation comprises multiplying, by the digital multiplier, the digital signal by a second factor, the second factor being a reciprocal of the first factor.
18. The method of embodiment 17, further comprising:
   measuring, by a calibrator, the first factor from the digital signal; and
   adjusting, by the calibrator, the second factor in response to the measuring.
19. The method of embodiment 15, wherein the first circuit comprises an analog adder and the second circuit comprises a digital adder, wherein the step of applying the first operation comprises summing, by the analog adder, the analog signal with a first addend, and wherein the step of applying the second operation comprises summing, by the digital adder, the digital signal with a second addend, the second addend being an additive inverse of the first addend.
20. The method of embodiment 19, further comprising:
   measuring, by a calibrator, the first addend from the digital signal; and
   adjusting, by the calibrator, the second addend in response to the measuring.

## Claims

1. A receiver, comprising:
a comparator configured to compare an analog signal and a reference signal;
an analog-to-digital converter (ADC) having an input configured to receive the analog signal and an output configured to supply a digital signal;
a first circuit configured to supply the analog signal to the input of the ADC, the first circuit configured to apply, under control by output of the comparator, a first operation to the analog signal; and
a second circuit configured to receive the digital signal from the output of the ADC, the second circuit configured to apply, under control of the output of the comparator, a second operation to the digital signal.

2. The receiver of claim 1, wherein the output of the comparator is a first state in response to an amplitude of the analog signal exceeding a range determined by the reference signal, wherein the first operation, in response to the output of the comparator being in the first state, is configured to reduce the amplitude of the analog signal, and wherein the second operation, in response to the output of the comparator being in the first state, is configured to increase the amplitude of the digital signal.

3. The receiver of claim 2, wherein the output of the comparator is a second state in response to the amplitude of the analog signal being within the range, wherein the first operation, in response to the output of the comparator being in the second state, is configured to pass the analog signal, and wherein the second operation, in response to the output of the comparator being in the second state, is configured to pass the digital signal.

4. The receiver of one of the previous claims, wherein the first circuit comprises an analog multiplier and the first operation is multiplication of the analog signal by a first factor, and wherein the second circuit comprises a digital multiplier and the second operation is multiplication of the digital signal by a second factor, the second factor being a reciprocal of the first factor
and/or
wherein the first circuit comprises an analog adder and the first operation is summation of the analog signal with a first addend, and wherein the second circuit comprises a digital adder and the second operation is summation of the digital signal with a second addend, the second addend being an additive inverse of the first addend.

5. The receiver of claim 3, further comprising a calibrator configured to adjust the second factor in response to measuring the first factor from the digital signal,
in particular,
the receiver further comprising a calibrator configured to adjust the second addend in response to measuring the first addend from the digital signal.

6. A receiver, comprising:
an analog front-end (AFE) configured to down-convert a radio frequency (RF) signal to generate a first analog signal;
a first circuit configured to generate a second analog signal;
a multiplexer configured to supply an analog signal as one of the first analog signal or the second analog signal;
a comparator configured to compare the analog signal and a reference signal;
an analog-to-digital converter (ADC) having an input configured to receive the analog signal and an output configured to supply a digital signal;
a second circuit configured to supply the analog signal to the input of the ADC, the second circuit configured to apply, under control by output of the comparator, a first operation to the analog signal; and
a third circuit configured to receive the digital signal from the output of the ADC, the third circuit configured to apply, under control of the output of the comparator, a second operation to the digital signal.

7. The receiver of claim 6, wherein the output of the comparator is a first state in response to an amplitude of the analog signal exceeding a range determined by the reference signal and a second state in response to the amplitude of the analog signal being within the range, wherein the first operation is configured to reduce the amplitude the analog signal in response to the output of the comparator being in first state and to pass the analog signal in response to the output of the comparator being in the second state, and wherein the second operation is configured to increase the amplitude of the digital signal in response to the output of the comparator being in the first state and pass the digital signal in response to the output of the comparator being in the second state,
in particular,
wherein the range is between -FS/X and +FS/X, where FS is a full-scale of the ADC and X is greater than or equal to one.

8. The receiver of claim 6 or 7, wherein the first analog signal comprises an orthogonal frequency division multiplexing (OFDM) signal
and/or
wherein the second analog signal comprises a training signal, and wherein the receiver further comprises a calibrator configured to: control the multiplexer to select between the first analog signal and the second analog signal; and calibrate the second operation in response to measuring the first operation from the digital signal.

9. The receiver of one of claims 6 to 8, wherein the second circuit comprises an analog multiplier and the first operation is multiplication of the analog signal by a first factor, and wherein the third circuit comprises a digital multiplier and the second operation is multiplication of the digital signal by a second factor, the second factor being a reciprocal of the first factor
and/or
wherein the second circuit comprises an analog adder and the first operation is summation of the analog signal with a first addend, and wherein the third circuit comprises a digital adder and the second operation is summation of the digital signal with a second addend, the second addend being an additive inverse of the first addend.

10. A method of analog-to-digital conversion in a receiver, comprising:
comparing, by a comparator, an analog signal and a reference signal;
converting, by an analog-to-digital converter (ADC), the analog signal to a digital signal;
applying, by a first circuit that supplies the analog signal to the ADC, a first operation to the analog signal under control of an output of the comparator; and
applying, by a second circuit that receives the digital signal from the ADC, a second operation to the digital signal under control of the output of the comparator.

11. The method of claim 10, wherein the output of the comparator is a first state in response to an amplitude of the analog signal exceeding a range determined by the reference signal, wherein the first operation, in response to the output of the comparator being in the first state, reduces the amplitude of the analog signal, and wherein the second operation, in response to the output of the comparator being in the first state, increases the amplitude of the digital signal.

12. The method of claim 10 or 11, wherein the first circuit comprises an analog multiplier and the second circuit comprises a digital multiplier, wherein the step of applying the first operation comprises multiplying, by the analog multiplier, the analog signal by a first factor, and wherein the step of applying the second operation comprises multiplying, by the digital multiplier, the digital signal by a second factor, the second factor being a reciprocal of the first factor.

13. The method of claim 12, further comprising:
measuring, by a calibrator, the first factor from the digital signal; and
adjusting, by the calibrator, the second factor in response to the measuring.

14. The method of one of claims 10 to 13, wherein the first circuit comprises an analog adder and the second circuit comprises a digital adder, wherein the step of applying the first operation comprises summing, by the analog adder, the analog signal with a first addend, and wherein the step of applying the second operation comprises summing, by the digital adder, the digital signal with a second addend, the second addend being an additive inverse of the first addend.

15. The method of claim 14, further comprising:
measuring, by a calibrator, the first addend from the digital signal; and
adjusting, by the calibrator, the second addend in response to the measuring.
